# EUROPEAN PATENT APPLICATION

(11) **EP 4 633 319 A1**
(43) Date of publication of application: **15.10.2025**
(21) Application number: 23900492.2
(22) Date of filing: 27.11.2023
(51) Int. Cl.: H10B 61/00, H10N 52/80

(54) **MAGNETIC MEMORY ELEMENT AND MEMORY SYSTEM**

(30) Priority: 07.12.2022 JP 2022195537
(71) Applicant: Sony Semiconductor Solutions Corporation, Atsugi-shi, Kanagawa 243-0014 (JP)
(72) Inventor: KAGEYAMA, Yuito, Atsugi-shi, Kanagawa 243-0014 (JP); HOSOMI, Masanori, Atsugi-shi, Kanagawa 243-0014 (JP); SAKAI, Lui, Atsugi-shi, Kanagawa 243-0014 (JP); KONOTO, Makoto, Tsukuba-shi, Ibaraki 305-8560 (JP)
(74) Representative: MFG Patentanwälte Meyer-Wildhagen Meggle-Freund Gerhard PartG mbB
(86) International application number: PCT/JP2023/042327
(87) International publication number: WO 2024/122375

(57) **Abstract**

To prevent a decrease in magnetic anisotropy modulation efficiency while improving crystallinity of a magnetic layer in a magnetic memory element. A magnetic memory element includes a storage layer having a variable magnetization direction and a voltage-controlled magnetic anisotropy effect, a reference layer having an invariable magnetization direction, a tunnel barrier layer disposed between the storage layer and the reference layer, and an underlayer disposed below the storage layer. The storage layer included in the magnetic memory element is configured to have a B content of 10at% or less. The underlayer included in the magnetic memory element is configured to have an orientation different from that of the tunnel barrier layer or to be in an amorphous state.

## Description

### Field

The present disclosure relates to a magnetic memory element and a memory system.

### Background

In a magnetoresistive RAM (MRAM) in which a magnetic memory element is employed as a nonvolatile storage element, a voltage-driven magnetic memory element that writes data by applying a pulse voltage has been proposed. For such an MRAM, a magnetic memory element having a magnetic tunnel junction (MTJ) structure in which a tunnel barrier layer is sandwiched between two magnetic layers (a storage layer and a reference layer) is used.

This magnetic memory element is in a high resistance state in a case where the directions of magnetization of the two magnetic layers are different, and is in a low resistance state in a case where the directions of magnetization are the same. The MRAM stores data using this change in resistance, and writing and reading of data can be stably performed as a resistance ratio is higher. In order to improve the resistance ratio, the crystal structure of the magnetic layer is an important factor. By forming the crystal structure of the magnetic layer in a (001) orientation, a high resistance ratio can be obtained.

Usually, MgO and FeCoB are used for the tunnel barrier layer and the magnetic layer, respectively (see, for example, Patent Literature 1). When B is contained in a FeCo alloy in the magnetic layer, the magnetic layer in an amorphous state can be formed. When MgO as the tunnel barrier layer is formed and stacked on the magnetic layer in the amorphous state, MgO is configured to have the (001) orientation. Thereafter, B of the magnetic layer is diffused by performing annealing, and FeCo is subjected to solid-phase epitaxial growth using MgO of the tunnel barrier layer as a template. As a result, the crystal structure of the magnetic layer can be configured to have the (001) orientation.

### Citation List

### Patent Literature

Patent Literature 1: JP 2019-057601 A

### Summary

### Technical Problem

However, the above-described conventional technique has a problem in that performance is deteriorated when applied to the voltage-driven magnetic memory element. This is because a magnetic layer having a voltage-controlled magnetic anisotropy (VCMA) effect is required for the voltage-driven magnetic memory element, but when the content of B is large, the magnetic anisotropy voltage modulation efficiency decreases. In this case, a high write voltage is required, and convenience is deteriorated.

Therefore, the present disclosure proposes a magnetic memory element that prevents a decrease in magnetic anisotropy modulation efficiency while improving crystallinity of a magnetic layer and maintaining a high resistance ratio, and a memory system using the magnetic memory element.

### Solution to Problem

A magnetic memory element according to the present disclosure includes: a storage layer having a variable magnetization direction and a voltage-controlled magnetic anisotropy effect; a reference layer having an invariable magnetization direction; a tunnel barrier layer disposed between the storage layer and the reference layer; and an underlayer disposed below the storage layer, wherein the storage layer is configured to have a B content of 10at% or less, and the underlayer is configured to have an orientation different from that of the tunnel barrier layer or to be in an amorphous state.

Furthermore, a memory system according to the present disclosure includes: a magnetic memory element including a storage layer having a variable magnetization direction and a voltage-controlled magnetic anisotropy effect, a reference layer having an invariable magnetization direction, a tunnel barrier layer disposed between the storage layer and the reference layer, and an underlayer disposed below the storage layer; and a memory control unit that controls writing and reading of data in the magnetic memory element, wherein the storage layer is configured to have a B content of 10at% or less, and the underlayer is configured to have an orientation different from that of the tunnel barrier layer or to be in an amorphous state.

### Brief Description of Drawings

FIG. 1 is a diagram illustrating a configuration example of a memory system according to an embodiment of the present disclosure.
FIG. 2 is a diagram illustrating a configuration example of a memory cell according to an embodiment of the present disclosure.
FIG. 3 is a diagram illustrating a configuration example of a magnetic memory element according to a first embodiment of the present disclosure.
FIG. 4 is a diagram illustrating another configuration example of the magnetic memory element according to the first embodiment of the present disclosure.
FIG. 5 is a diagram illustrating an example of writing in a magnetic memory element according to an embodiment of the present disclosure.
FIG. 6 is a diagram illustrating an example of a method for manufacturing a magnetic memory element according to an embodiment of the present disclosure.
FIG. 7 is a diagram illustrating an example of a processing procedure of write processing of a magnetic memory element according to an embodiment of the present disclosure.
FIG. 8 is a diagram illustrating an example of write processing of a magnetic memory element according to an embodiment of the present disclosure.
FIG. 9 is a diagram illustrating a configuration example of a magnetic memory element according to a second embodiment of the present disclosure.
FIG. 10 is a diagram illustrating a configuration example of the magnetic memory element according to the second embodiment of the present disclosure.
FIG. 11 is a diagram illustrating another configuration example of the magnetic memory element according to the second embodiment of the present disclosure.
FIG. 12 is a diagram illustrating another configuration example of the magnetic memory element according to the second embodiment of the present disclosure.
FIG. 13 is a diagram illustrating another configuration example of the magnetic memory element according to the second embodiment of the present disclosure.
FIG. 14 is a diagram illustrating another configuration example of the magnetic memory element according to the second embodiment of the present disclosure.

### Description of Embodiments

Hereinafter, embodiments of the present disclosure will be described in detail with reference to the drawings. The description will be given in the following order. Note that in the following embodiments, the same parts are denoted by the same reference numerals, and redundant description will be omitted.
1. First Embodiment
2. Second Embodiment

### (1. First Embodiment)

### [Configuration of Memory System]

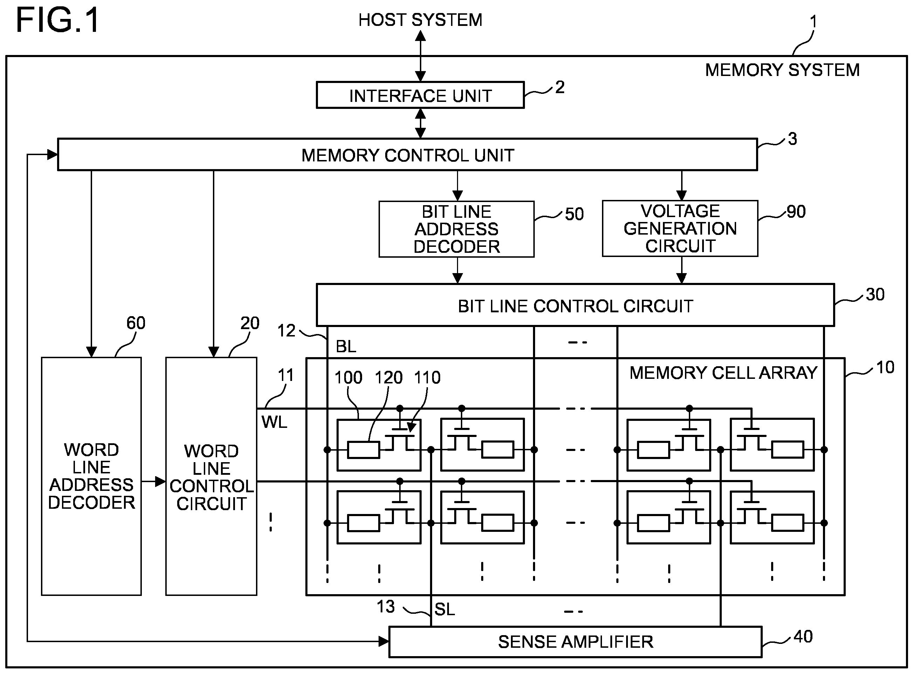

FIG. 1 is a diagram illustrating a configuration example of a memory system according to an embodiment of the present disclosure. FIG. 1 is a block diagram illustrating a configuration example of a memory system 1. The memory system 1 includes an interface unit 2, a memory control unit 3, a memory cell array 10, a word line address decoder 60, a word line control circuit 20, a bit line address decoder 50, a bit line control circuit 30, and a sense amplifier 40. In addition, the memory system 1 further includes a voltage generation circuit 90. Note that in the present embodiment, an example in which a memory interface connected to a host system is provided is described, but the memory system 1 can also be applied to an embedded memory, a mixed memory, and a mixed storage having an I/O connected to a system on a chip (SoC) mixed internal bus or a logic circuit.

The interface unit 2 performs exchange with a host system or the like using the memory system 1.

The memory control unit 3 performs exchange with the host system or the like. The memory control unit 3 receives a command from the host system or the like, and controls writing and reading of data on the basis of the received command. The memory control unit 3 in FIG. 1 outputs write and read addresses to the word line address decoder 60 and the bit line address decoder 50. In addition, the memory control unit 3 outputs a control signal to the word line control circuit 20 and the voltage generation circuit 90. In addition, the memory control unit 3 sends write data to the sense amplifier 40 and acquires read data from the sense amplifier 40.

The memory cell array 10 is configured by arranging memory cells 100 that store data in a two-dimensional matrix. The memory cell 100 includes a magnetic memory element 120 and a selection element 110.

For the magnetic memory element 120, for example, a magnetoresistive effect element such as an MTJ element can be used. The MTJ element is an element in which a nonmagnetic insulating layer is disposed between two ferromagnetic layers, and is an element in which a resistance value changes according to magnetization directions of the two ferromagnetic layers. The MTJ element is in a high resistance state in a case where the directions of magnetization of the two ferromagnetic layers are different, and is in a low resistance state in a case where the directions of magnetization are the same. Note that a state in which the magnetization directions are the same is referred to as a parallel state, and a state in which the magnetization directions are different is referred to as an antiparallel state. The direction of magnetization can be changed by applying a write voltage to the MTJ element. For example, it is possible to store 1-bit data by associating the values "0" and "1" with the low resistance state and the high resistance state of the MTJ element, respectively. Note that the values "0" and "1" can also be referred to as a low level voltage (L) and a high level voltage (H).

The selection element 110 is an element that is connected to one end of the magnetic memory element 120 and controls application of a voltage to the magnetic memory element 120. For example, an n-channel MOS transistor can be applied to the selection element 110.

A word line 11 (WL) and a bit line 12 (BL) for transmitting a control signal are connected to the memory cell 100. In addition, in the memory cell 100, a source line 13 (SL) for transmitting a signal from the magnetic memory element 120 is further disposed. In the memory cell array 10, a plurality of word lines are wired in a row direction, and a plurality of bit lines and source lines are wired in a column direction.

The word line address decoder 60 selects a word line of the memory cell array 10 on the basis of the control signal from the memory control unit 3.

The word line control circuit 20 outputs the control signal to the word line selected by the word line address decoder 60.

The bit line address decoder 50 selects a bit line of the memory cell array 10 on the basis of the control signal from the memory control unit 3.

The bit line control circuit 30 outputs the control signal to the bit line selected by the bit line address decoder 50.

The sense amplifier 40 reads data by detecting a current flowing through the memory cell 100 at the time of reading. The read data is output to the memory control unit 3. In addition, the sense amplifier 40 applies a write voltage to the memory cell 100 at the time of writing.

The voltage generation circuit 90 is a circuit that generates a voltage to be applied at the time of writing and reading of the memory cell 100.

Writing to the memory cell 100 is performed in a case where storage data of the memory cell 100 is different from the write data. That is, data is read from the memory cell 100, and the read data and the write data are compared. As a result of this comparison, writing is performed in a case where they are different. In this case, writing can be performed by inverting the storage data of the memory cell 100. That is, writing can be performed by inverting a storage state of the magnetic memory element 120. The storage state of the magnetic memory element 120 can be inverted by applying a write voltage at a predetermined voltage to the magnetic memory element 120. Details of writing in the magnetic memory element 120 will be described later.

Reading can be performed by applying a predetermined read voltage to the magnetic memory element 120 of the memory cell 100 and detecting a current flowing through the memory cell 100. Note that the read voltage is preferably a voltage having a polarity different from that of the write voltage.

### [Memory Cell]

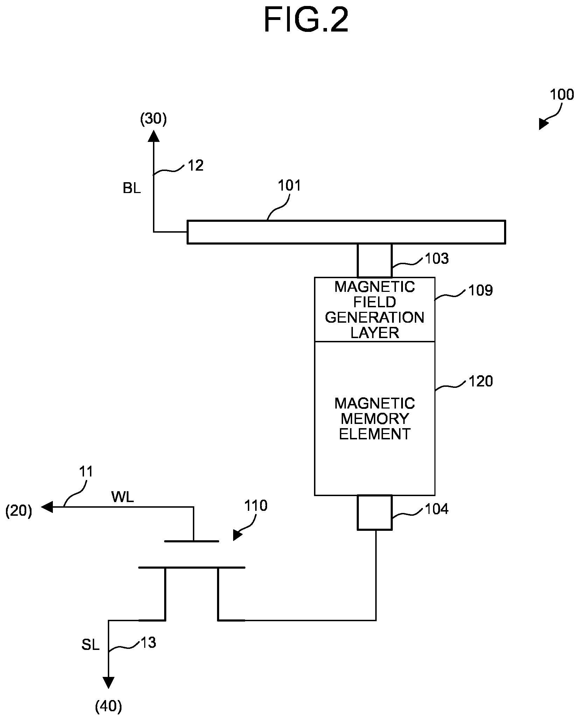

FIG. 2 is a diagram illustrating a configuration example of a memory cell according to an embodiment of the present disclosure. FIG. 2 is a schematic diagram illustrating a configuration example of the memory cell 100. As described above, the memory cell 100 includes the magnetic memory element 120 and the selection element 110.

The magnetic memory element 120 is connected to a wiring 101 and the like via contact layers 103 and 104. As described later, the magnetic memory element 120 is configured by stacking a storage layer 122, a reference layer 125, and the like. The configuration of the magnetic memory element 120 will be described later.

A drain of the selection element 110 is connected to the contact layer 104 of the magnetic memory element 120, and a source thereof is connected to the source line 13 (SL). In addition, a gate of the selection element 110 is connected to the word line 11 (WL). Note that the contact layer 103 on the reference layer 111 side of the magnetic memory element 120 is connected to the wiring 101 constituting the bit line 12 (BL). By applying an on-voltage to the word line 11 (WL), the selection element 110 is conducted, and a current according to the applied voltage of the magnetic memory element 120 can flow.

As described above, the word line 11 (WL) is connected to the word line control circuit 20. The bit line 12 (BL) is connected to the bit line control circuit 30. The source line 13 (SL) is connected to the sense amplifier 40. By applying a voltage between the bit line 12 (BL) and the source line 13 (SL) and applying the on-voltage for conducting the selection element 110 to the word line 11 (WL), a voltage for writing or reading can be applied to the magnetic memory element 120.

In addition, a magnetic field generation layer 109 is disposed in the magnetic memory element 120 in FIG. 2. The magnetic field generation layer 109 applies a magnetic field in a direction (horizontal direction in FIG. 2) perpendicular to a stacking direction of the storage layer 122 and the like of the magnetic memory element 120.

Note that the configuration of the memory cell 100 is not limited to this example. For example, the positions of the magnetic field generation layer 109 and the magnetic memory element 120 can be interchanged. In addition, for example, any one of the contact layers 103 and 104 can be configured as a magnetic field generation layer. In this case, the magnetic field generation layer 109 can be omitted. In addition, a magnet layer may be formed above or below the magnetic memory element 120, and a magnetic field may be applied using a leakage magnetic field. In addition, by inserting an antiferromagnetic layer into the magnetic memory element 120, an exchange bias magnetic field from the antiferromagnetic layer can be applied. In addition, it is also possible to use a magnetic field generated by arranging a wiring parallel to the horizontal direction of the magnetic memory element 120 above the wiring 101 or below the magnetic memory element 120 and causing a current to flow. In addition, a method of applying a magnetic field by arranging a permanent magnet around the memory cell array 10 can also be adopted.

### [Magnetic Memory Element]

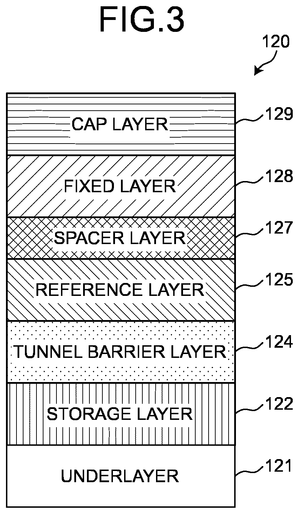

FIG. 3 is a diagram illustrating a configuration example of a magnetic memory element according to a first embodiment of the present disclosure. FIG. 3 is a cross-sectional view illustrating a configuration example of the magnetic memory element 120. The magnetic memory element 120 in FIG. 3 includes an underlayer 121, the storage layer 122, a tunnel barrier layer 124, the reference layer 125, a spacer layer 127, a fixed layer 128, and a cap layer 129. In addition, the magnetic memory element 120 in FIG. 3 is configured by sequentially stacking the underlayer 121, the storage layer 122, the tunnel barrier layer 124, the reference layer 125, the spacer layer 127, the fixed layer 128, and the cap layer 129.

The underlayer 121 is a layer serving as a base of the storage layer 122. The underlayer 121 can be configured to have a different orientation from (001). Specifically, the underlayer 121 can be formed in a body centered cubic lattice (bcc), a face centered cubic lattice (fcc), a hexagonal close-packed lattice (hcp), or an amorphous state. The underlayer 121 can be made of a metal such as Cr, Ta, Ru, Au, Ag, Cu, Al, Ti, V, Mo, Zr, Hf, Re, W, Pt, Pd, Ir, or Rh, or an alloy containing these metals. In addition, the underlayer 121 can also be configured by stacking these metals. In addition, the underlayer 121 can also be made of a conductive nitride such as TiN. For example, the underlayer 121 in FIG. 3 can be formed of Ta (thickness: 5 nm) and Ru (thickness: 10 nm) sequentially formed.

The storage layer 122 is a ferromagnetic layer having magnetic anisotropy and a variable magnetization direction. A state in which the magnetization direction of the storage layer 122 is the same as the magnetization direction of the reference layer 125 and a state in which the magnetization direction of the storage layer is different from the magnetization direction of the reference layer correspond to the parallel state and the anti-parallel state, respectively. The magnetic memory element 120 is in the low resistance state in the parallel state, and is in the high resistance state in the antiparallel state. As described above, by applying a voltage to the magnetic memory element 120, the magnetization direction of the storage layer 122 can be reversed.

As described above, the storage layer 122 can be made of CoFe. In addition, the storage layer 122 may include a ferromagnetic material containing at least one of Fe, Co, Ni, and Mn in addition to CoFe. In addition, another element can be added to the storage layer 122 in order to increase the VCMA efficiency, control the interface magnetic anisotropy energy, adjust the saturation magnetization, control the magnetocrystalline anisotropy energy, and adjust the crystal grain size and the intergranular bond. As the element added to the storage layer 122, for example, at least one of Ir, Os, Pt, Rh, Hf, Zr, Ti, Ta, W, Re, Au, Mo, Ru, Pd, Y, V, Sc, Gd, Tb, La, Mg, Al, Ag, Cu, and Cr can be applied. The storage layer 122 in FIG. 3 can be made of, for example, CoFe (thickness: 0.8 nm).

The thickness of the storage layer 122 is desirably 3 nm or less. This is because the magnetization direction due to the interface magnetic anisotropy during standby can be controlled in a direction perpendicular to a film surface. In addition, it is more preferable to adjust the film thickness of the storage layer 122 to 1.5 nm or less. This is because the anisotropy modulation effect by an applied voltage can be improved.

In addition, it is also possible to add a substrate cooling process before or during the formation of the storage layer 122. At this time, the temperature reached by a wafer (substrate) can be, for example, 0°C or less. Since the storage layer 122 can be configured to be in the amorphous state without being affected by the orientation of the underlayer 121 by the addition of the cooling process, MgO of the tunnel barrier layer to be described later can be grown in the (001) orientation. For example, cooling sputtering can be applied to the cooling process.

Thereafter, by applying an annealing treatment, CoFe of the storage layer 122 can be configured to have the (001) orientation using MgO as a template. The temperature reached by the wafer (substrate) at the time of annealing can be, for example, in a range of 250°C or more and 500°C or less. Through these steps, CoFe of the storage layer 122 and MgO of the tunnel barrier layer can be in the (001) orientation. As a result, a high magnetoresistance ratio can be obtained, and a read margin can be increased. In addition, the magnetic anisotropy energy can be improved, and a holding force can be increased. In addition, the VCMA efficiency can be improved, and a write voltage can be reduced.

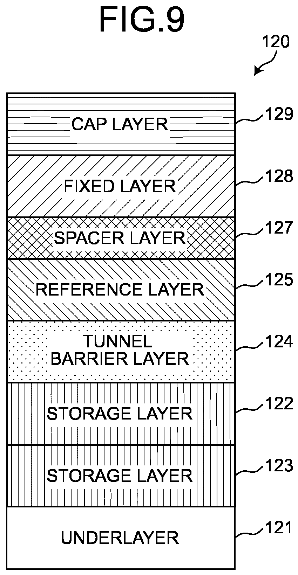

As described above, CoFe of the storage layer 122 can be formed in the amorphous state even in a case where B is not contained. Note that a configuration including a plurality of storage layers as illustrated in FIG. 9 to be described later can also be adopted. Even in this case, CoFe in which the content of B is approximately 0% can be used for the storage layer adjacent to the tunnel barrier layer 124. Note that in a case where a plurality of storage layers are provided, the concentration of B in all the storage layers including the storage layer 122 is desirably 7at% or less. This is to prevent a decrease in VCMA efficiency. In addition, the B concentration of all the storage layers including the storage layer 122 is more desirably 5at% or less. This is to reduce thermal diffusion in a case where a thermal load is applied by a wafer process or annealing.

The tunnel barrier layer 124 is disposed adjacent to the storage layer 122, and applies an electric field to the storage layer 122 to impart a voltage-controlled magnetic anisotropy effect. In addition, the tunnel barrier layer 124 is a layer that separates the storage layer 122 from the reference layer 125. The tunnel barrier layer 124 in FIG. 3 can be made of, for example, MgO (thickness: 2.0 nm).

Note that the tunnel barrier layer 124 can be made of an oxide of at least one element selected from the group of Mg, Al, Ti, Si, Zn, Zr, Hf, Ta, Bi, Cr, Ga, La, Gd, Sr, and Ba, or a nitride of at least one element selected from the group of Mg, Al, Ti, Si, Zn, Zr, Hf, Ta, Bi, Cr, Ga, La, Gd, Sr, and Ba. In addition, it can also be configured using an insulator such as MgF₂, CaF, SrTiO₂, AlLaO₃, or AlNO, a dielectric, and a semiconductor. Note that the tunnel barrier layer 124 is also referred to as an insulating layer.

The reference layer 125 is a ferromagnetic layer having magnetic anisotropy and an invariable magnetization direction. The magnetization direction of the reference layer 125 is controlled in a direction perpendicular to a film surface by magnetic anisotropy. The reference layer 125 can include a ferromagnetic layer containing at least one of Fe, Co, Ni, and Mn. The reference layer 125 desirably does not include B similarly to the storage layer 122. This is to improve the VCMA effect at an interface. The reference layer 125 in FIG. 3 can be made of, for example, CoFe (thickness: 1.0 nm).

The fixed layer 128 is a ferromagnetic layer having magnetic anisotropy and a fixed magnetization direction. The magnetization direction of the fixed layer 128 is controlled in a direction perpendicular to a film surface by magnetic anisotropy. In addition, the magnetization direction of the fixed layer 128 is configured to be antiparallel to the magnetization direction of the reference layer 125. A leakage magnetic field applied from the reference layer 125 to the storage layer 122 can be canceled by the fixed layer 128. The fixed layer 128 contains Co and at least one element of Ni, Pt, and Pd, and can be formed of an alloy or an artificial lattice of CoPt, CoNi, and CoPd. The fixed layer 128 in FIG. 3 can be made of, for example, PtCo (thickness: 2.0 nm).

Note that the magnetic memory element 120 in FIG. 3 illustrates an example of a top-pin type configuration in which the fixed layer 128 is formed above the tunnel barrier layer 124 and the storage layer 122 is formed below the tunnel barrier layer 124. Note that the fixed layer 128 may be formed below the tunnel barrier layer 124 and the storage layer 122 may be formed above the tunnel barrier layer 124 in a bottom-pin type configuration. An example of the bottom-pin type magnetic memory element 120 will be described in a second embodiment.

The spacer layer 127 is a film that separates the reference layer 125 from the fixed layer 128. The spacer layer 127 can be made of at least one of Ru, Ir, Rh, and Re.

The cap layer 129 is a layer that prevents diffusion of a metal from a wiring member. The cap layer 129 can be made of a metal such as Cr, Ta, Ru, Au, Ag, Cu, Al, Ti, V, Mo, Zr, Hf, Re, W, Pt, Pd, Ir, or Rh. In addition, the cap layer 129 can also include a layer made of an alloy containing these metals, or a transition metal element. In addition, the cap layer 129 can also be configured by stacking them. In addition, the cap layer 129 can also be made of a conductive nitride such as TiN. The cap layer 129 in FIG. 3 can be formed of, for example, Ru (thickness: 7 nm) and Ta (thickness: 5 nm) sequentially formed.

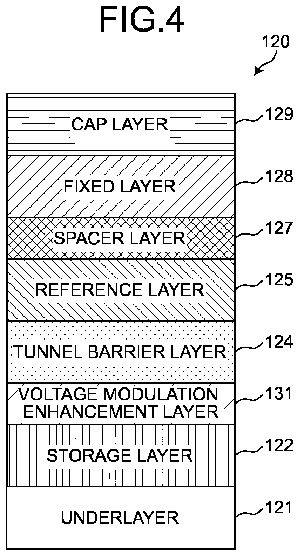

FIG. 4 is a diagram illustrating another configuration example of the magnetic memory element according to the first embodiment of the present disclosure. FIG. 4 is a cross-sectional view illustrating a configuration example of the magnetic memory element 120, similarly to FIG. 3. The magnetic memory element 120 in FIG. 4 is different from the magnetic memory element 120 in FIG. 3 in that a voltage modulation enhancement layer 131 is disposed between the storage layer 122 and the tunnel barrier layer 124.

The voltage modulation enhancement layer 131 improves the VCMA efficiency. The interface magnetic anisotropy energy can also be controlled by disposing the voltage modulation enhancement layer 131 between the storage layer 122 and the tunnel barrier layer 124. The voltage modulation enhancement layer 131 can be made of at least one of Ir, Os, Pt, Rh, Hf, Zr, Ti, Ta, W, Re, Au, Mo, Ru, Pd, Y, V, Sc, Gd, Tb, La, Mg, Al, Ag, Cu, Cr, Co, Fe, Ni, and the like, or an oxide thereof.

### [Writing]

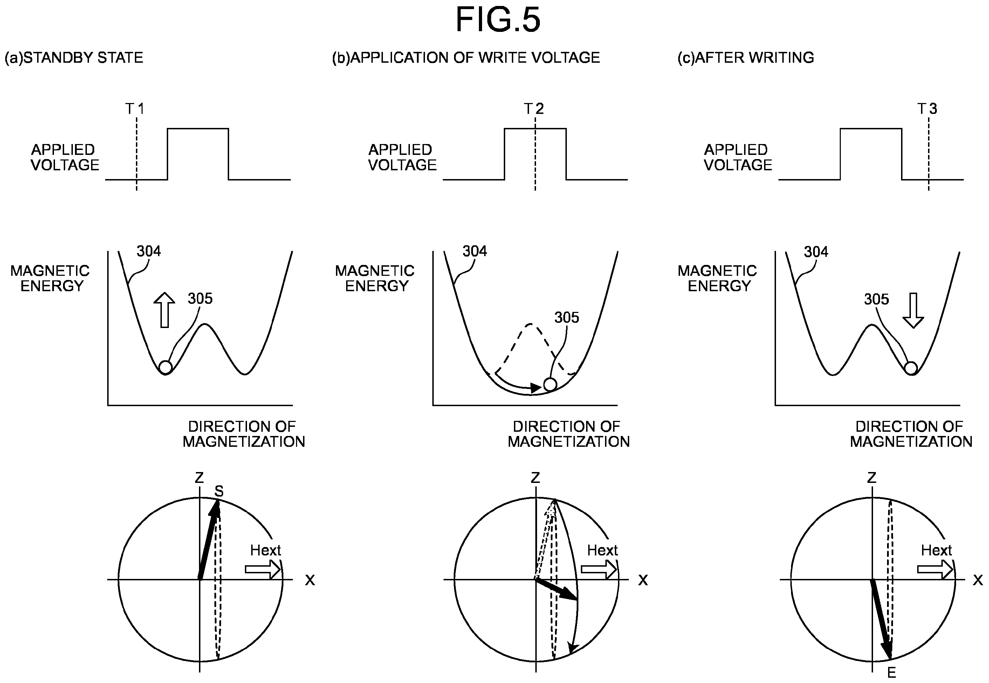

FIG. 5 is a diagram illustrating an example of writing in a magnetic memory element according to an embodiment of the present disclosure. FIG. 5 is a diagram for explaining writing in the magnetic memory element 120. The upper part of FIG. 5 illustrates a write voltage waveform of the magnetic memory element 120. The middle part of FIG. 5 illustrates a state of magnetization energy of the storage layer 122 in a process of writing. In the middle diagram of FIG. 5, the horizontal axis represents the direction of magnetization, and the vertical axis represents magnetic energy. The curve in this drawing represents a magnetization energy curve 304 indicating a relationship between the magnetization direction and the magnetic energy, and a white circle 305 represents a direction in which a magnetization vector is directed. Two valley regions in which the direction of magnetization represented by the white circle 305 is vertically upward or vertically downward with respect to a film surface are energetically stable regions. In addition, a peak between the regions represents the height of energy when the magnetization is directed in an in-plane direction. The lower part of FIG. 5 is a diagram schematically illustrating the movement of magnetization of the magnetic layer due to the VCMA effect. Note that when the write voltage is applied, a magnetic field Hext in a direction perpendicular to a direction in which the storage layer 122 and the reference layer 125 are stacked is applied.
(a) illustrates a standby state (T1 in the upper part of FIG. 5) before the write voltage is applied. In this state, as illustrated in the middle part of FIG. 5, the magnetization energy curve 304 has a shape having two valleys. In addition, in the lower part of FIG. 5, the direction of the magnetization vector (thick arrow) is S in a positive direction of a z axis.
(b) illustrates a state (T2 in the upper part of FIG. 5) in which the write voltage is applied. In this state, as illustrated in the middle part of FIG. 5, the magnetization energy curve 304 has a downward convex shape. As a result, the magnetization vector of the storage layer 122 starts precession. A thin arrow in the lower diagram of FIG. 5 represents a trajectory of the precession.
(c) illustrates a state (T3 in the upper part of FIG. 5) after writing. This state represents a state in which the application of the write voltage is stopped when the direction of the magnetization vector moves to the opposite side beyond the peak of the magnetization energy curve 304. The white circle 305 moves to the opposite valley and the magnetization direction is reversed. In addition, as illustrated in the lower diagram of FIG. 5, the magnetization vector is E in a negative direction of the z axis.

As described above, writing can be performed in the magnetic memory element 120. Note that the time for applying the write voltage needs to be substantially equal to the time for reversing the magnetization direction.

### [Method for Manufacturing Magnetic Memory Element]

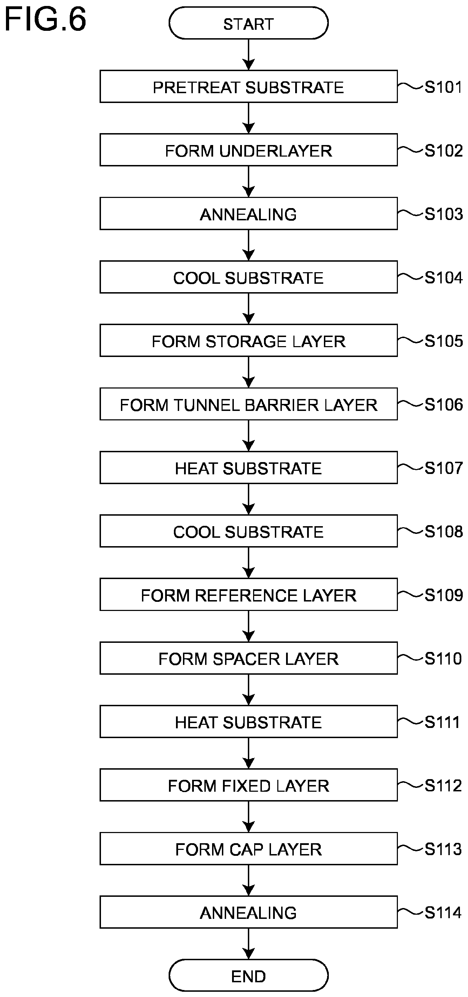

FIG. 6 is a diagram illustrating an example of a method for manufacturing a magnetic memory element according to an embodiment of the present disclosure. FIG. 6 is a flowchart illustrating an example of a manufacturing process of the magnetic memory element 120. In FIG. 6, the underlayer 121 and the like can be formed by a known method such as sputtering. First, a substrate is pretreated (step S101). This is a step of pretreating the substrate (wafer) on which the magnetic memory element 120 is formed. This pretreatment corresponds to treatment of degassing and pre-clean etching of the substrate.

Next, the underlayer 121 is formed on the substrate (step S102). Next, annealing is performed (step S103). This annealing can be performed by heating the substrate to a temperature of 150°C or more and 450°C or less in vacuum.

Next, the substrate is cooled (step S104). This can be performed by cooling the substrate to a temperature of 0°C or less. Next, the storage layer 122 is formed (step S105). This can be performed by the cooling sputtering described above. Next, the tunnel barrier layer 124 is formed (step S106). Next, the substrate is heated (step S107). This can be performed by heating the substrate to a temperature of 100°C or more and 300°C or less. Note that this substrate heating step can also be performed in the step of step S106.

Next, the substrate is cooled (step S108). This can be performed by cooling the substrate to a temperature of 0°C or less. Next, the reference layer 125 is formed (step S109). Next, the substrate is returned to room temperature to form the spacer layer 127 (step S110). Next, the substrate is heated (step S111). This can be performed by heating the substrate to a temperature of 250°C or more and 500°C or less. Note that this substrate heating step can also be performed in the next step of step S112.

Next, the fixed layer 128 is formed (step S112). Next, the cap layer 129 is formed (step S113). Next, annealing is performed (step S114). This annealing can be performed by heating the substrate to a temperature of 250°C or more and 500°C or less.

### [Write Processing Procedure]

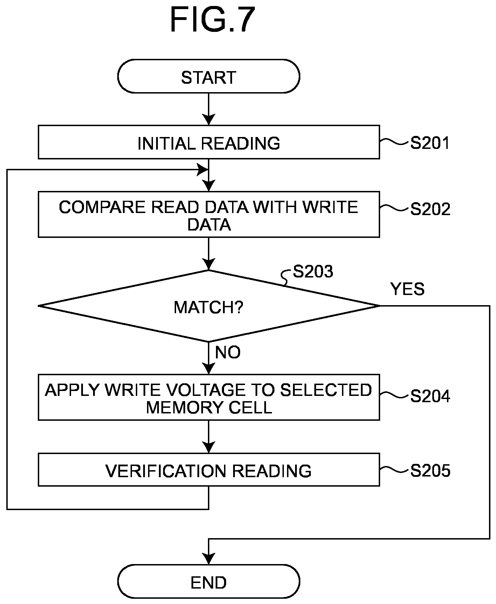

FIG. 7 is a diagram illustrating an example of a processing procedure of write processing of a magnetic memory element according to an embodiment of the present disclosure. FIG. 7 is a flowchart illustrating an example of a processing procedure of write processing of the magnetic memory element 120. First, the memory control unit 3 performs initial reading (step S201). This can be performed by reading data held in the magnetic memory element 120 of the memory cell 100 as a write target. Next, the memory control unit 3 compares the read data with the write data (step S202). As a result, if they do not match (step S203, No), the memory control unit 3 applies a write voltage to the selected memory cell 100 (step S204). Next, the memory control unit 3 performs verification reading of the memory cell 100 on which writing has been performed (step S205). Next, the memory control unit 3 proceeds to the processing of step S202. Note that in step S203, if the read data and the write data match (step S203, Yes), the memory control unit 3 ends the write processing.

### [Write Processing]

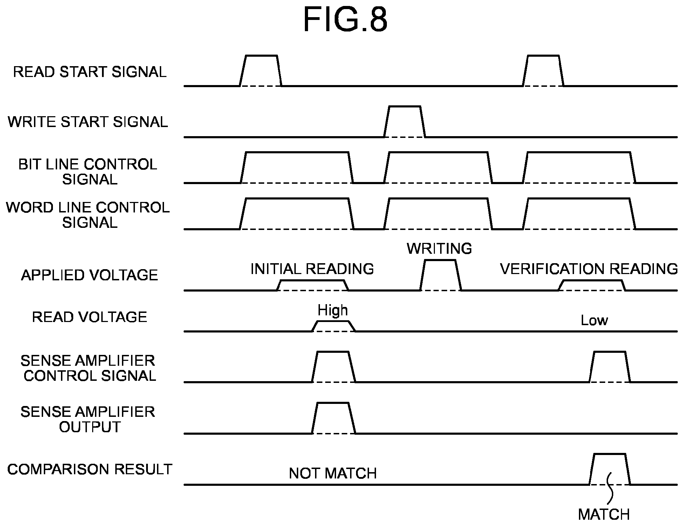

FIG. 8 is a diagram illustrating an example of write processing of a magnetic memory element according to an embodiment of the present disclosure. FIG. 8 is a timing chart illustrating an example of write processing of the magnetic memory element 120. In FIG. 8, the "read start signal", the "write start signal", the "bit line control signal", the "word line control signal", and the "sense amplifier control signal" represent waveforms of the read start signal, the write start signal, the bit line control signal, the word line control signal, and the sense amplifier control signal, respectively. In addition, the "applied voltage" represents a waveform of a voltage generated by the voltage generation circuit 90. The "read voltage" represents a waveform of the read voltage of the magnetic memory element 120. The "sense amplifier output" represents a waveform of a signal output from the sense amplifier 40 to the memory control unit 3. The "comparison result" represents a comparison result of data read from the memory element 120 with write data of the memory element 120.

The read start signal and the write start signal are generated by the memory control unit 3. The bit line 12 and the word line 11 are selected by the bit line address decoder 50 and the word line address decoder 60, respectively. The bit line control signal and the word line control signal are generated by the bit line control circuit 30 and the word line control circuit 20, respectively. The applied voltage corresponds to a voltage of a signal to be an input to the sense amplifier 40 at the time of reading and writing. Note that the read voltage in FIG. 8 schematically represents a difference between the high resistance state (High) and the low resistance state (Low) of the magnetic memory element 120 when the voltage is applied. Note that the actual signal waveforms are not limited to this diagram.

The sense amplifier control signal is a signal for controlling the timing for determining read data. The sense amplifier 40 determines whether the magnetic memory element 120 is in the high resistance state (High) or the low resistance state (Low), and outputs a determination result to the memory control unit 3. On the basis of the determination result, the memory control unit 3 determines whether the write data and the read data match.

The operation will be described in chronological order. The memory control unit 3 outputs the read start signal and an address to the voltage generation circuit 90, the bit line address decoder 50, and the word line address decoder 60. The bit line address decoder 50 and the word line address decoder 60 decode the address and output a control signal to the corresponding bit line 12 and word line 11. Next, the voltage generation circuit 90 generates a read voltage and applies the read voltage to the bit line 12 to perform initial reading. The read voltage changes to High or Low depending on whether the magnetic memory element 120 has a high resistance or a low resistance. When the sense amplifier control signal is output after the read voltage is determined, a read result is output from the sense amplifier 40.

The memory control unit 3 compares the write data with the read data, and ends the processing if they match. On the other hand, if they do not match, a write signal is output. FIG. 8 illustrates an example of a case where they do not match. After the corresponding bit line control signal and word line control signal are turned on, a write voltage is applied. Further, the memory control unit 3 performs reading for verification, and ends the write processing when the read data matches the write data. This verification reading control can be the same as the control for initial reading. In addition, the verification reading may be performed at a read voltage different from the initial reading. In the example of FIG. 8, an example in which writing succeeds with one voltage application has been described, but a write voltage may be applied again if writing fails.

Note that the write control is not limited to this example. The start signal and the like may also be unnecessary depending on a circuit design, and the timing for controlling the bit line and the word line is arbitrary. Although FIG. 8 illustrates an example of writing, any reading method can be applied to reading.

As described above, in the magnetic memory element 120 according to the first embodiment of the present disclosure, a film is formed while cooling CoFe in which the content of B is approximately 0% to form the storage layer 122 in the amorphous state. The tunnel barrier layer 124 made of MgO is formed on the storage layer 122. Since the storage layer 122 is in the amorphous state, the tunnel barrier layer 124 is crystal-grown in the (001) orientation of MgO. Thereafter, by performing annealing, CoFe of the storage layer 122 is subjected to solid-phase epitaxial growth in the (001) orientation on the basis of the crystal plane of MgO of the tunnel barrier layer 124. As a result, it is possible to reduce the content of B in the storage layer 122 while improving the crystallinity of the storage layer 122 and maintaining a high resistance ratio, and it is possible to prevent a decrease in magnetic anisotropy modulation efficiency.

Note that the method for manufacturing a magnetic layer not including B according to the present disclosure can be applied to an element other than the magnetic memory element 120, for example, to a magnetic head. The performance of a hard disk device can be improved by applying the magnetic head to which the method for manufacturing a magnetic layer according to the present disclosure is applied to the hard disk device.

### (2. Second Embodiment)

Variations of the magnetic memory element 120 of the first embodiment described above will be described.

### [Configuration of Magnetic Memory Element]

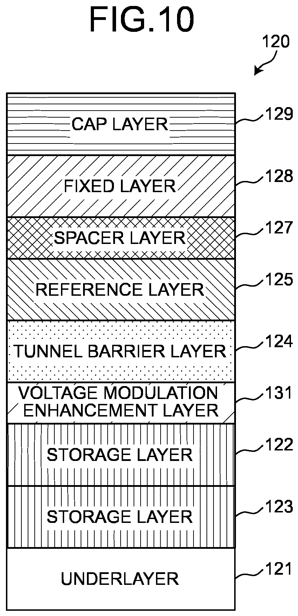

FIGS. 9 and 10 are diagrams illustrating configuration examples of a magnetic memory element according to a second embodiment of the present disclosure. FIGS. 9 and 10 are diagrams illustrating configuration examples of a magnetic memory element 120, similarly to FIGS. 3 and 4. The magnetic memory element 120 in FIGS. 9 and 10 is different from the magnetic memory element 120 in FIGS. 3 and 4 in further including a storage layer 123. FIGS. 9 and 10 illustrate examples of a case where a plurality of storage layers are provided. Among them, for the storage layer 122 close to the tunnel barrier layer 124, CoFe in which the content of B is approximately 0% can be used.

The storage layer 123 is configured to contain at least one of Fe, Co, Ni, and Mn, and may contain at least one element of B, C, Mg, Y, Si, Al, Ta, Zr, Hf, and a rare earth element in order to adjust the saturation magnetization, control the magnetocrystalline anisotropy energy, and adjust the crystal grain size and the intergranular bond. Note that as described above, the content of B is desirably set to 10at% in all the storage layers including the storage layers 122 and 123.

In FIGS. 9 and 10, the storage layer 123 can be made of, for example, CoFeB (thickness: 0.5 nm). The storage layer 122 can be made of, for example, CoFe (thickness: 0.5 nm). Other configurations are the same as those in FIGS. 3 and 4, and thus the description thereof is omitted.

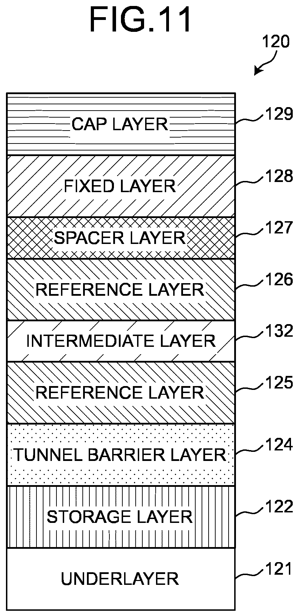

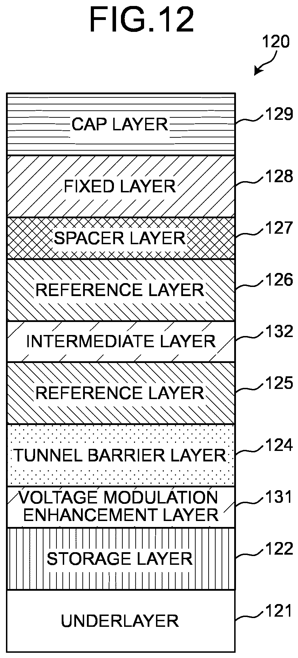

FIGS. 11 and 12 are diagrams illustrating other configuration examples of the magnetic memory element according to the second embodiment of the present disclosure. FIGS. 11 and 12 are diagrams illustrating configuration examples of the magnetic memory element 120, similarly to FIGS. 3 and 4. The magnetic memory element 120 in FIGS. 11 and 12 is different from the magnetic memory element 120 in FIGS. 3 and 4 in further including a reference layer 126 and an intermediate layer 132.

The reference layer 126 in FIGS. 11 and 12 is configured to contain at least one of Fe, Co, Ni, and Mn, and may contain at least one element of B, C, Mg, Y, Si, Al, Ta, Zr, Hf, Pt, Pd, and a rare earth element in order to adjust the saturation magnetization, control the magnetocrystalline anisotropy energy, and adjust the crystal grain size and the intergranular bond.

The intermediate layer 132 is a layer interposed between the reference layers 125 and 126. The intermediate layer 132 is a layer containing, for example, at least one of Ta, W, Nb, Mo, Cr, V, Re, Ru, Ir, Cu, Rh, Co, Fe, Ni, and B.

In FIGS. 11 and 12, the reference layer 125 can be made of, for example, CoFe (thickness: 0.8 nm). The intermediate layer 132 can be made of, for example, Mo (thickness: 0.35 nm). The reference layer 126 can be made of, for example, Co (thickness: 0.7 nm). The fixed layer 128 can be made of, for example, PtCo (thickness: 3.0 nm). Other configurations are the same as those in FIGS. 3 and 4, and thus the description thereof is omitted.

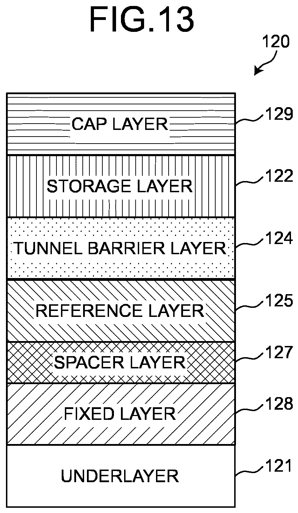

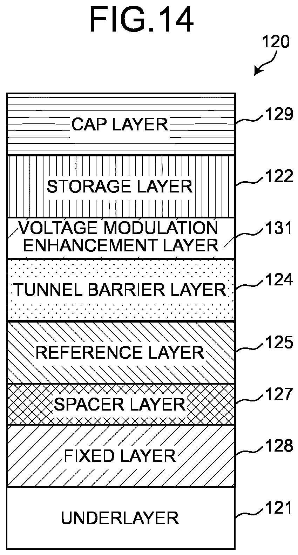

FIGS. 13 and 14 are diagrams illustrating other configuration examples of the magnetic memory element according to the second embodiment of the present disclosure. FIGS. 13 and 14 are diagrams illustrating configuration examples of the magnetic memory element 120, similarly to FIGS. 3 and 4. The magnetic memory element 120 in FIGS. 13 and 14 is different from the magnetic memory element 120 in FIGS. 3 and 4 in that it is configured as a bottom-pin type.

Since the configuration of the magnetic memory element 120 other than this is similar to the configuration of the magnetic memory element 120 in the first embodiment of the present disclosure, the description thereof will be omitted.

Although the embodiments of the present disclosure have been described above, the technical scope of the present disclosure is not limited to the above-described embodiments as they are, and various modifications can be made without departing from the gist of the present disclosure. In addition, components of different embodiments and modifications may be appropriately combined.

In addition, the processing described using the flowchart and the sequence diagram in the present specification may not necessarily be executed in the illustrated order. Some processing steps may be performed in parallel. In addition, additional processing steps may be employed, and some processing steps may be omitted.

Note that the effects described in the present specification are merely examples and are not limited, and other effects may be provided.

Note that the present technology can also have the following configurations.
(1) A magnetic memory element comprising:
   a storage layer having a variable magnetization direction and a voltage-controlled magnetic anisotropy effect;
   a reference layer having an invariable magnetization direction;
   a tunnel barrier layer disposed between the storage layer and the reference layer; and
   an underlayer disposed below the storage layer, wherein
   the storage layer is configured to have a B content of 10at% or less, and
   the underlayer is configured to have an orientation different from that of the tunnel barrier layer or to be in an amorphous state.
(2) The magnetic memory element according to the above (1), wherein the tunnel barrier layer is configured to have a (001) orientation.
(3) The magnetic memory element according to the above (1) or (2), wherein in the storage layer, a surface facing the tunnel barrier layer is (001) oriented.
(4) The magnetic memory element according to the above (3), wherein the storage layer is formed in an amorphous state, and the surface facing the tunnel barrier layer is (001) oriented by heat treatment.
(5) The magnetic memory element according to the above (4), wherein the storage layer is formed in the amorphous state by at least one of cooling in a film forming step of the storage layer and cooling of a substrate in a step before the film forming step.
(6) The magnetic memory element according to the above (5), wherein the storage layer is formed in the amorphous state by the cooling at 0°C or less.
(7) The magnetic memory element according to any one of the above (1) to (6), wherein the storage layer is configured to contain CoFe.
(8) The magnetic memory element according to any one of the above (1) to (7), wherein the tunnel barrier layer is made of an oxide of at least one of Mg, Ca, Li, Si, Sr, Zr, Hf, Ti, Sc, La, Ta, Eu, Cu, Ba, Mo, W, V, Y, Ni, Co, Mn, Cr, and Fe.
(9) The magnetic memory element according to any one of the above (1) to (8), further comprising a voltage modulation enhancement layer disposed between the storage layer and the tunnel barrier layer.
(10) The magnetic memory element according to the above (9), wherein the voltage modulation enhancement layer is made of at least one of Ir, Os, Pt, Rh, Hf, Zr, Ti, Ta, W, Re, Au, Mo, Ru, Pd, Y, V, Sc, Gd, Tb, La, Mg, Al, Ag, Cu, Cr, Co, Fe, and Ni, or an oxide thereof.
(11) A memory system comprising:
   a magnetic memory element including
   a storage layer having a variable magnetization direction and a voltage-controlled magnetic anisotropy effect,
   a reference layer having an invariable magnetization direction,
   a tunnel barrier layer disposed between the storage layer and the reference layer, and
   an underlayer disposed below the storage layer; and
   a memory control unit that controls writing and reading of data in the magnetic memory element, wherein
   the storage layer is configured to have a B content of 10at% or less, and
   the underlayer is configured to have an orientation different from that of the tunnel barrier layer or to be in an amorphous state.

### Reference Signs List

- 1: MEMORY SYSTEM
- 3: MEMORY CONTROL UNIT
- 10: MEMORY CELL ARRAY
- 100: MEMORY CELL
- 120: MAGNETIC MEMORY ELEMENT
- 121: UNDERLAYER
- 122, 123: STORAGE LAYER
- 124: TUNNEL BARRIER LAYER
- 125, 126: REFERENCE LAYER
- 127: SPACER LAYER
- 128: FIXED LAYER
- 129: CAP LAYER
- 131: VOLTAGE MODULATION ENHANCEMENT LAYER
- 132: INTERMEDIATE LAYER

## Claims

1. A magnetic memory element comprising:
a storage layer having a variable magnetization direction and a voltage-controlled magnetic anisotropy effect;
a reference layer having an invariable magnetization direction;
a tunnel barrier layer disposed between the storage layer and the reference layer; and
an underlayer disposed below the storage layer, wherein
the storage layer is configured to have a B content of 10at% or less, and
the underlayer is configured to have an orientation different from that of the tunnel barrier layer or to be in an amorphous state.

2. The magnetic memory element according to claim 1, wherein the tunnel barrier layer is configured to have a (001) orientation.

3. The magnetic memory element according to claim 1, wherein in the storage layer, a surface facing the tunnel barrier layer is (001) oriented.

4. The magnetic memory element according to claim 3, wherein the storage layer is formed in an amorphous state, and the surface facing the tunnel barrier layer is (001) oriented by heat treatment.

5. The magnetic memory element according to claim 4, wherein the storage layer is formed in the amorphous state by at least one of cooling in a film forming step of the storage layer and cooling of a substrate in a step before the film forming step.

6. The magnetic memory element according to claim 5, wherein the storage layer is formed in the amorphous state by the cooling at 0°C or less.

7. The magnetic memory element according to claim 1, wherein the storage layer is configured to contain CoFe.

8. The magnetic memory element according to claim 1, wherein the tunnel barrier layer is made of an oxide of at least one of Mg, Ca, Li, Si, Sr, Zr, Hf, Ti, Sc, La, Ta, Eu, Cu, Ba, Mo, W, V, Y, Ni, Co, Mn, Cr, and Fe.

9. The magnetic memory element according to claim 1, further comprising a voltage modulation enhancement layer disposed between the storage layer and the tunnel barrier layer.

10. The magnetic memory element according to claim 9, wherein the voltage modulation enhancement layer is made of at least one of Ir, Os, Pt, Rh, Hf, Zr, Ti, Ta, W, Re, Au, Mo, Ru, Pd, Y, V, Sc, Gd, Tb, La, Mg, Al, Ag, Cu, Cr, Co, Fe, and Ni, or an oxide thereof.

11. A memory system comprising:
a magnetic memory element including
a storage layer having a variable magnetization direction and a voltage-controlled magnetic anisotropy effect,
a reference layer having an invariable magnetization direction,
a tunnel barrier layer disposed between the storage layer and the reference layer, and
an underlayer disposed below the storage layer; and
a memory control unit that controls writing and reading of data in the magnetic memory element, wherein
the storage layer is configured to have a B content of 10at% or less, and
the underlayer is configured to have an orientation different from that of the tunnel barrier layer or to be in an amorphous state.
